(19) Europäisches Patentamt
European Patent Office
Office européen des brevets

(11) Publication number: **0 587 917 B1**

(12) **EUROPEAN PATENT SPECIFICATION**

(45) Date of publication of patent specification: **04.01.95**

(51) Int. Cl.$^{6}$: **C23G 5/032**, C11D 7/50, C11D 7/32, C11D 1/44, C11D 3/43

(21) Application number: **92113503.4**

(22) Date of filing: **07.08.92**

(54) **Cleaning agent.**

(43) Date of publication of application:
**23.03.94 Bulletin 94/12**

(45) Publication of the grant of the patent:
**04.01.95 Bulletin 95/01**

(84) Designated Contracting States:
**AT CH DE DK FR GB IE LI NL PT SE**

(56) References cited:
**EP-A- 0 231 886**
**EP-A- 0 330 379**
**EP-A- 0 426 512**
**WO-A-91/00332**
**FR-A- 2 644 174**

(73) Proprietor: **DR.O.K. WACK CHEMIE GmbH**
**Bunsenstrasse 6**
**D-85053 Ingolstadt (DE)**

(72) Inventor: **Wack, Oskar, Dr.**
**c/o Dr. O.K. Wack Chemie GmbH,**
**Bunsenstrasse 6**
**W-8070 Ingolstadt (DE)**
Inventor: **Hanek Martin, Dr.**
**c/o Dr. O.K. Wack Chemie GmbH,**
**Bunsenstrasse 6**
**W-8070 Ingolstadt (DE)**

(74) Representative: **Le Vrang, Klaus**
**Fliederstrasse 1**
**D-85139 Wettstetten (DE)**

EP 0 587 917 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The invention relates to a cleaning agent, especially to a cleaning liquid used for the cleaning of electronic components, circuit boards, electronic assembly units, and precision mechanics or optical parts.

Especially electronic circuit boards are cleaned after the components have been mounted thereon, and the components have been soldered. Residues or films of grease, resins and similar disposals are disadvantegous to the resistance between the individual electronic components and could lead to a malfunction of the whole circuit. The high density of the components on modern circuit boards increases the problems encountered.

For cleaning the components and the printing boards in the past CFC's have been used. Due to the problems now recognized to be caused by the CFC's (ozone-killer) there is an absolute need to avoid the further use of the CFC's.

It is therefor one object of the invention to propose a cleaning agent which is free of CFC's.

It is a further object of the invention to propose a cleaning agent for electronic components which is free of CFC's and additionally contains no halogens and does not harm the environment.

Another object of the invention is to provide a CFC-free cleaning agent having outstanding cleaning performances.

Still another object of the invention is to provide a cleaning agent for electronic components and optical parts which has a high flash point so that no explosion-proof equipment is required under operation.

It is still another object of the invention to propose a cleaning agent for electronic components and/or optical components having biologically degradable components.

These objects are met by the cleaning agent as claimed in claim 1.

According to the invention there is described a cleaning liquid for the use in cleaning electronic assembly units and optical components, said agent containing absolutely no CFC's.

a carrier compound, said carrier compound being a dipropylene glycol monoether of the common formula

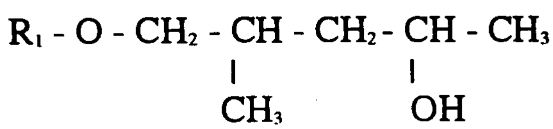

whereby $R_1$ is chain of carbon atoms of a length between 1 and 6 atoms,

10 - 30 % per weight of a polypropylene glycol ether of the formula:

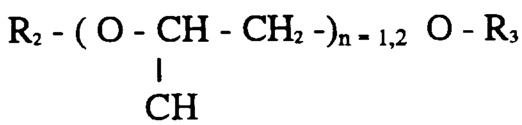

whereby $R_2$ is a chain of carbon atoms of a length between 1 and 6, and $R_3$ is a chain of hydrogen or carbon atoms of a length between 1 and 6 atoms, and

2 - 15 % per weight of an active substance selected from one of the following compounds or a mixture thereof:

a. Compounds of the formula

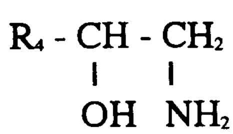

whereby $R_4$ is a chain of 1 to 6 carbon atoms

b. Compounds of the formula

$N(R_5)_3$ whereby $R_5$ is a chain of 2 to 18 carbon atoms,

c. Compounds of the formula

$R_6$ - N[($CH_2$ - $CH_2O$)$_n$ H] whereby $R_6$ is a chain of 8 to 18 carbon atoms and n is number between 2 and 25.

The great advantage of this cleaning agent, in comparison to the cleaning agents according to the prior art, lies in the fact that by using the agent according to this formulation it is possible to clean electronic circuit boards from any residues of flux agents having few solids. Said flux agents with poor solids are introduced into electronic production to avoid a cleaning by CFCs. Due to the prohibition of CFCs many manufacturers are only using soldering means without solids or with only few solids so that the cleaning process can be reduced. Nevertheless a certain number of the circuit boards produced still has to be cleaned. Of course no manufacturer of circuit boards and user of such cleaning agents is interested in the appliance of two different flux agents depending on whether the boards have to be cleaned or not. By the product according to the invention there is offered for the first time a cleaning agent which is able to remove the residues without leaving a white film disturbing the optical apparence and the asthetic look of the boards.

A special composition of the of the cleaning liquid according to the invention which overcomes the problems stated above consists of a mixture comprising

80 % by weight of ethoxypropoxypropanol,

15 % by weight dipropylene glycol dimethyl ether, and

5 % by weight aminobutanol.

This cleaning mixture is completely free of CFC's and aditionally has the following advantages:

No waste of water since according to the invention there is provided a semiaqueous process for cleaning the components, said process generating absolutely no waste water due to the closed loop system.

Outstanding cleaning performances.

Very good dissolution of flux agents and oils.

Cleaning process free of residual waste gases and effluents.

High flash point. No explosion-proof equipment is required where temperatures of 40 °c to 60 °C are not exceeded.

Minimal evaporation loss.

No toxic components, absolutely no health hazard.

Completely halogen-free (CFC, C and CC) and therefore absolutely no threat of erosion to the ozone layer is presented nor is there a danger of contamination of the water supply.

Biologically degradable components according to OECD test methods.

The cleaning process requires only ca. 20 - 25 % of the amount of CFC cleaning media previously used. This results in a ca. 20 - 30 % reduction in the costs of chemicals as compared with CFC's.

The mixture consisting of highly effective solvents with very good water solubility ensures the easy removal of oil, grease and resin residues. The mixture, free of wetting agent, removes even ionic compounds, such as flux activators.

For the appliance of the cleaning agent there is provided a process having at least three stages. In stage 1 the items to be cleaned are immersed into a bath consisting of one of the mixtures described above. Depending on the special materials to be cleaned and to the special residues or film the most suitable mixture will be used. It could be of advantage to test some of the mixtures until the mixture having the best cleaning properties is found for this special case. The cleaning liquid is at room temperature or at a temperature of about 40 to 50 °C. The items will usually be kept in this bath for a period of less than two minutes. If necessary the cleaning process can be assisted by ultrasonic exposure or other suitable mechanical means.

Filters are provided to retain the particles removed. The solution can be used until the impurity level has reached about 20 %. Then the solution will be returned to the producer for reprocessing.

The second step is water rinsing to remove the cleaning solution. The rinsing water is kept in a closed loop circulation and pumped through resin adsorbers in a mixed-bed exchanger. If necessary, this rinsing step can be followed by a further rinsing step using deionised and/or demineralized water. The most suitable adsorber resins are styrol resins.

In the last step the items will be dried by a warm air stream or with warm air at 60 °C to 70 °C and a pressure of 2 bar.

In the following the invention will be disclosed in detail by one example and by the drawing, which shows

Fig. 1 a schematic cleaning station using the liquid of the invention in four steps, and

Fig. 2 a schematic cleaning station using the liquid of the invention in three steps.

Example

A mixture is prepared consisting of 80 % by weight of ethoxypropoxypropanol, 15 % by weight dipropylene glycol dimethyl ether, and 5 % by weight aminobutanol.. The individual components are added together at room temperature and stirred.

The mixture obtained has the following properties:

| | |
|---|---|
| Density: | 0.93 ± 0.02 g/cm$^3$ |
| Surface-tension: | 29.0 mN/m |
| Boiling-range: | 175 - 228 °C |
| Flash point | 73 °C |

The following matrix shows the efficency of different cleaning liquids, compared with the one according to the invention (this mixture is referred to as mixture A):

| | Kind of pollution | | | | |
|---|---|---|---|---|---|
| cleaning method | grease | ionically dissociatable compositions | resins | harmful to ozonlayer | temperature |
| CFC/ alcohol | + | O | O | yes | 25 °C |
| alcohol | + | O | O | no | 25 °C |
| water/ alcalic | O | + | O | no | 25 °C |
| terpene/ water | + | + | O | no | 25 °C |
| butylglycol/ alcohol | + | O | O | no | 25 °C |
| mixture A/ rinsing with water | + | + | + | no | 25 °C |

+ means "very good", o means "good", - means "bad"

The mixture has been found to be especially suitable for cleaning flux agents with few solids from electronic components. Further applications are cleaning of optical parts and mechanical components. The solvating properties for oil, grease, and soldering pastes have been found to be excellent.

Reference is now made to the drawing. Fig. 1 shows an apparatus for the application of the cleaning mixtures and the cleaning process according to the invention. Reference numeral 10 shows a device having four tanks 12, 14, 16, and 18. In this first tank there is provided an ultrasonic radiator 20 with standard intensity ultrasonics. According to the special items to be cleaned this first tank 12 is filled with a bath of one of the mixtures according to the above described examples, the most suitable mixture is found by

tests. The items to be cleaned are immersed into this first tank for about 60 to 120 sec. Simultanously they are exposed to the ultrasonic radiation.

Thereafter the items are taken out and immersed into the second tank 14 containing rinsing water. The subsequent washing in tank 16 with demineralized or deionised water helps to avoid any residues on the items when thereafter dried in tank 18 by a stream of hot air.

The cleaning mixtures according to the invention are filtered by filter 22.

The rinsing water is pumped in closed loops 24 and 26 over adsorber resins which can be regenerated when saturated by the residues brought into the bath. Styrol resins have been found to be most suitable for use in connection with these special cleaning liquids.

Fig. 2 shows a more simple three stage device. Reference numeral 110 designates a device having three tanks 112, 114, and 116. In this first tank 112 there is provided an ultrasonic radiator 120 with standard intensity ultrasonics. Accordings to the special items to be cleaned this first tank 112 is filled with a bath of one of the mixtures according to the above described examples, the most suited mixture is again found by tests. The items to be cleaned are immersed int this first tank for about 60 to 120 sec. Simultanously they are exposed to the ultrasonic radiation.

Thereafter the items are taken out and immersed into the second tank 114 containing rinsing water. Thereafter they are dried in tank 116 by a stream of hot air.

The cleaning mixtures according to the invention are filtered by filter 122. The rinsing water is pumped in a closed loop 124 absorber resins which can be regenerated when saturated by the residues brought into the bath.

## Claims

**1.** Cleaning agent consisting of:

a carrier compound, said carrier compound being a dipropylene glycol monoether of the common formula

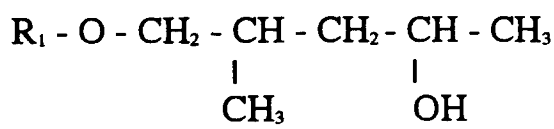

whereby $R_1$ is chain of carbon atoms of a length between 1 and 6 atoms,
10 - 30 % per weight of a polypropylene glycol ether of the formula:

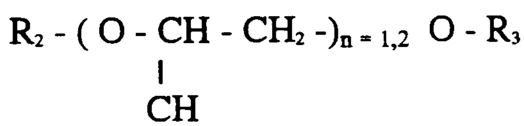

whereby $R_2$ is a chain of carbon atoms of a length between 1 and 6, and $R_3$ is a chain of hydrogen or carbon atoms of a length between 1 and 6 atoms, and
2 - 15 % per weight of an active substance selected from one of the following compounds or a mixture thereof:

a. Compounds of the formula

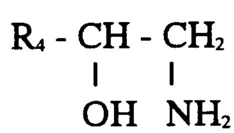

whereby $R_4$ is a chain of 1 to 6 carbon atoms

b. Compounds of the formula
$N(R_5)_3$ whereby $R_5$ is a chain of 2 to 18 carbon atoms,
c. Compounds of the formula
$R_6 - N[(CH_2 - CH_2O)_n H]$ whereby $R_6$ is a chain of 8 to 18 carbon atoms, an $1 < n < 26$.

**2.** Cleaning agent according to claim 1, characterized in that as carrying agent there is provided ethoxypropoxypropanol.

**3.** Cleaning agent according to claim 1 or 2, characterized in that as polypropylene glycol ether there is provided dipropylene glycol dimethyl ether.

**4.** Cleaning agent according to claims 1 to 3, characterized in that as active substance there is provided aminobutanol.

**5.** Cleaning agent according to one of the foregoing claims, characterized in that it is composed of
80 % by weight of ethoxypropoxypropanol,
15 % by weight dipropylene glycol dimethyl ether, and
5 % by weight aminobutanol.

**6.** A method of cleaning units, especially electronic assembly units or optical parts, comprising
1. immersing the units to be cleaned into a bath consisting of a cleaning agent according to one of the claims 1 to 5,
2. providing a second bath for water rinsing the units to be cleaned, and
3. drying the units in a warm air stream or with warm air.

**7.** A method according to claim 6, characterized in that for enhancing the cleaning performance the units are additionally exposed to ultrasonic appliance or agitation when immersed into the cleaning bath.

**8.** A method according to claim 6 or 7, characterized in that the water of the second bath is circulated over resin adsorbers and in a mixed bed exchanger in a closed loop.

**9.** A method according to one of the claims 6 to 8, characterized in that between the second bath and the drying step there is provided a third bath for final rinse using completely demineralized and/or deionised water.

**10.** A method according to claim 9, characterized in that the adsorber resins consist of styrol resin.

**Patentansprüche**

**1.** Reinigungsmittel, bestehend aus
einer Trägerzusammensetzung, die ein Dipropylenglykolmonoether der allgemeinen Formel

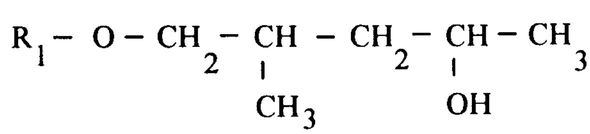

ist,
wobei $R_1$ eine Kohlenstoffkette mit einer Länge von 1 bis 6 Atomen ist,
10 bis 30 Gewichtsprozent ein Polypropylenglykolether der Formel

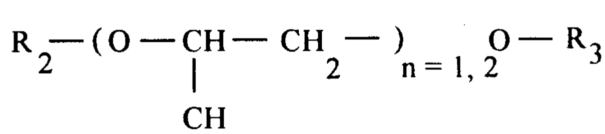

,

wobei $R_2$ eine Kohlenstoffkette von 1 bis 6 Kohlenstoffatomen und $R_3$ eine Kette von Wasserstoff- oder Kohlenstoffatomen mit einer Länge zwischen 1 und 6 Atomen ist, und
2 bis 15 Gewichtsprozent einer aktiven Substanz, ausgewählt aus einer der folgenden Verbindungen oder eines Gemisches davon:

a. Verbindungen der Formel

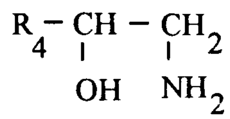 ,

wobei $R_4$ eine Kette von 1 bis 6 Kohlenstoffatomen ist,

b. Verbindungen der Formel

$N(R_5)_3$ ,

wobei $R_5$ eine Kette von 2 bis 18 Kohlenstoffatomen ist,

c. Verbindungen der Formel

$R_6 - N[(CH_2 - CH_2O)_n H]$

wobei R6 eine Kette von 8 bis 18 Kohlenstoffatomen ist und $1<n<26$.

**2.** Reinigungsmittel nach Anspruch 1, dadurch gekennzeichnet, daß das Trägermittel Ethoxypropoxypropanol ist.

**3.** Reinigungsmittel nach Anspruch 1 oder 2, dadurch gekennzeichnet, daß als Polypropylenglykolether Dipropylenglykoldimethylether verwendet wird.

**4.** Reinigungsmittel nach den Ansprüchen 1 bis 3, dadurch gekennzeichnet, daß als aktive Substanz Aminobutanol verwendet wird.

**5.** Reinigungsmittel nach einem der vorhergehenden Ansprüche, dadurch gekennzeichnet, daß sie zusammengesetzt ist aus
80 Gew% Ethoxypropoxypropanol,
15 Gew% Dipropylenglykoldimethylether, und
5 Gew% Aminobutanol.

**6.** Verfahren zur Reinigung von Gegenständen, insbesondere von elektronischen Komponenten oder optischen Teilen, mit folgenden Schritten:

1. die zu reinigenden Gegenstände werden in ein Reinigungsmittel entsprechend einem der Ansprüche 1 bis 5 eingetaucht,
2. es ist ein zweites Bad zum Abspülen der zu reinigenden Gegenstände mit Wasser vorgesehen, und
3. die Gegenstände werden in einem warmen Luftstrom oder mit Warmluft getrocknet.

**7.** Verfahren nach Anspruch 6, dadurch gekennzeichnet, daß zur Verbesserung der Reinigungswirkung die Gegenstände zusätzlich einer Ultraschallbehandlung oder - anwendung unterzogen werden, wenn sie ins Bad eingetaucht werden.

**8.** Verfahren nach Anspruch 6 oder 7, dadurch gekennzeichnet, daß das Wasser des zweiten Bades über Adsorberharze und einen Mischbettaustauscher in einem geschlossenen Kreislauf geführt werden.

**9.** Verfahren nach einem der Ansprüche 6 bis 8, dadurch gekennzeichnet, daß zwischen dem zweiten Bad und dem Trocknen ein drittes Bad zur Endspülung unter Verwendung vollständig demineralisierten und entsalzten und/oder deionisierten Wassers vorgesehen ist.

**10.** Verfahren nach Anspruch 9, dadurch gekennzeichnet, daß die Adsorberharze aus Styrolharzen bestehen.

**Revendications**

**1.** Agent de nettoyage consistant en :

- un composé support, ledit composé support étant un monoéther de dipropylèneglycol de formule générale

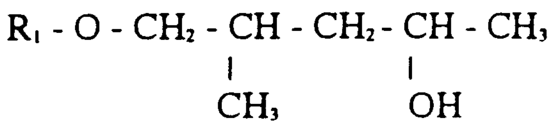

dans laquelle $R_1$ est une chaîne d'atomes de carbone d'une longueur de 1 à 6 atomes,

- 10 à 30% en poids d'un éther de polypropylèneglycol de formule

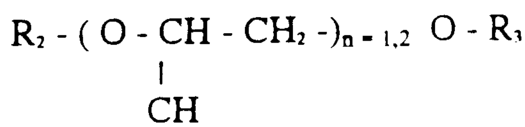

dans laquelle $R_2$ est une chaîne d'atomes de carbone d'une longueur de 1 à 6 atomes et $R_3$ est un atome d'hydrogène ou une chaîne d'atomes de carbone d'une longueur de 1 à 6 atomes, et

- 2 à 15% en poids d'une substance active choisie parmi les composés suivants ou leurs mélanges:

a. Composés de formule

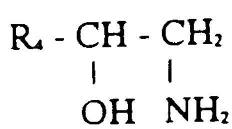

dans laquelle $R_4$ est une chaîne de 1 à 6 atomes de carbone

b. Composés de formule

$N(R_5)_3$

dans laquelle $R_5$ est une chaîne de 2 à 18 atomes de carbone,

c. Composés de formule

$R_6 - N[(CH_2 - CH_2O)_n H]$

dans laquelle $R_6$ est une chaîne de 8 à 18 atomes de carbone et $1 < n < 26$.

**2.** Agent de nettoyage selon la revendication 1, caractérisé en ce qu'on utilise de l'éthoxypropoxypropanol comme composé support.

**3.** Agent de nettoyage selon la revendication 1 ou 2, caractérisé en ce qu'on utilise de l'éther diméthylique de dipropylèneglycol comme éther de polypropylèneglycol.

**4.** Agent de nettoyage selon l'une quelconque des revendications 1 à 3, caractérisé en ce qu'on utilise de l'aminobutanol comme substance active.

**5.** Agent de nettoyage selon l'une quelconque des revendications précédentes, caractérisé en ce qu'il est composé de
   80% en poids d'éthoxypropoxypropanol,
   15% en poids d'éther diméthylique de dipropylèneglycol, et
   5% en poids d'aminobutanol.

**6.** Procédé de nettoyage de pièces, en particulier de pièces d'ensembles électroniques ou de pièces optiques, consistant à
   1. immerger les pièces à nettoyer dans un bain consistant en un agent de nettoyage selon l'une quelconque des revendications 1 à 5,
   2. utiliser un second bain pour le rinçage à l'eau des pièces à nettoyer, et
   3. sécher les pièces dans un courant d'air chaud ou avec de l'air chaud.

**7.** Procédé selon la revendication 6, caractérisé en ce que, pour améliorer les performances de nettoyage, les pièces sont en outre soumises à des ultrasons ou une agitation pendant qu'elles sont immergées dans le bain de nettoyage.

**8.** Procédé selon la revendication 6 ou 7, caractérisé en ce que l'eau du second bain est mise en circulation sur des résines adsorbantes et dans un échangeur à lit mixte en boucle fermée.

**9.** Procédé selon l'une quelconque des revendications 6 à 8, caractérisé en ce que, entre le second bain et l'étape de séchage, on prévoit un troisième bain pour un rinçage final en utilisant de l'eau totalement déminéralisée et/ou désionisée.

**10.** Procédé selon la revendication 9, caractérisé en ce que les résines adsorbantes consistent en résine de styrène.

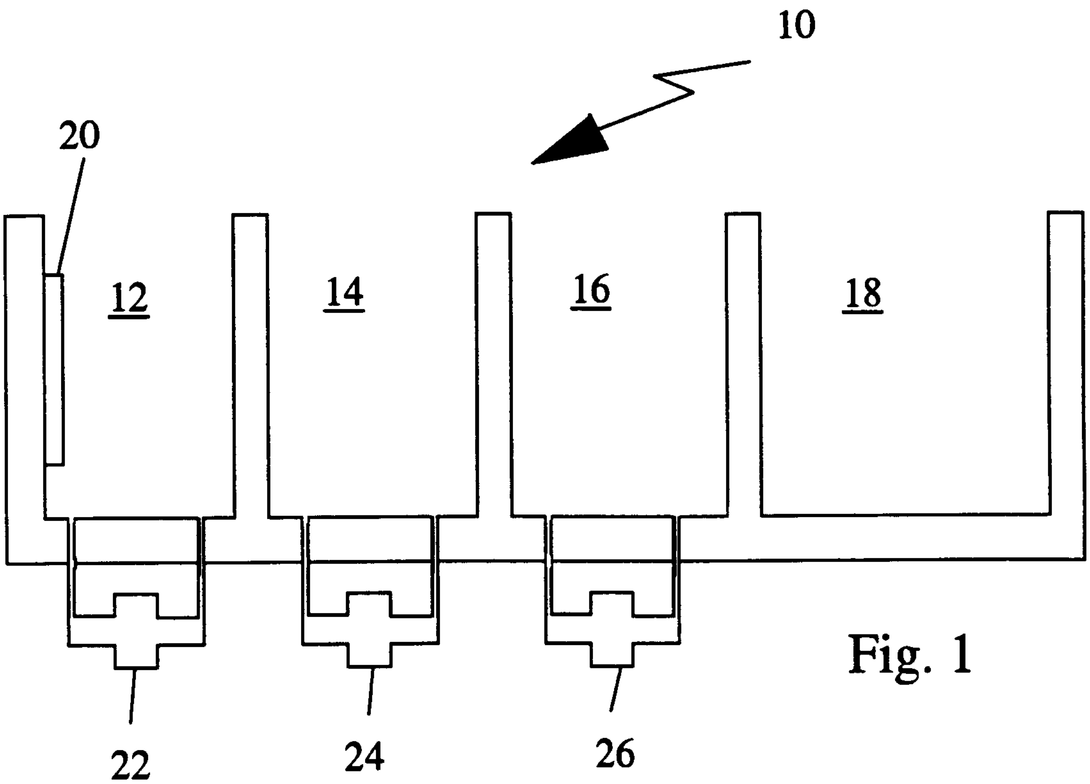


Fig. 1

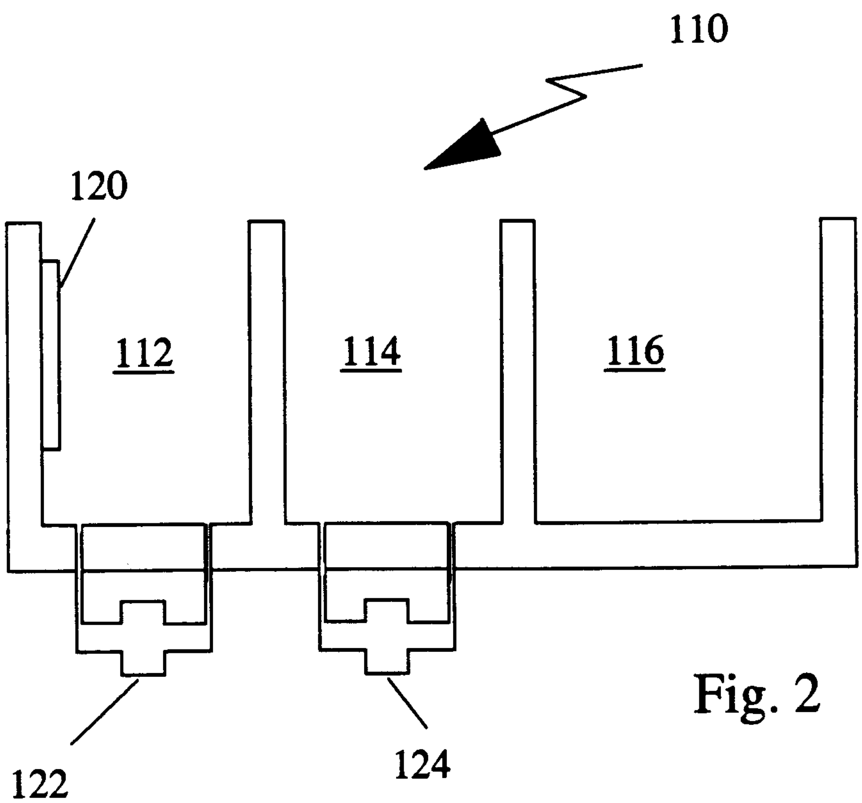


Fig. 2